# EUROPÄISCHE PATENTSCHRIFT

(11) **EP 3 662 508 B1**
(45) Veröffentlichungstag und Bekanntmachung des Hinweises auf die Patenterteilung: **01.02.2023**
(21) Anmeldenummer: 18712086.0
(22) Anmeldetag: 02.03.2018
(51) Int. Cl.: H01L 23/29, H01L 23/31, C04B 28/34, C04B 41/50, C04B 22/06, C04B 24/12, C04B 14/04, C04B 14/22, C04B 14/30, C04B 14/32, C04B 14/36, C04B 111/00

(54) **ZUSAMMENSETZUNG ZUR HERSTELLUNG EINER WÄSSRIGEN UMHÜLLUNGSMASSE**
COMPOSITION FOR PREPARING AN AQUEOUS COATING MATERIAL
COMPOSITION POUR LA FABRICATION D'UNE MATIÈRE DE REVÊTEMENT AQUEUSE

(30) Priorität: 31.07.2017 EP 17183915; 08.11.2017 EP 17200559
(43) Veröffentlichungstag der Anmeldung: 10.06.2020
(73) Patentinhaber: Heraeus Deutschland GmbH & Co. KG, 63450 Hanau (DE)
(72) Erfinder: SCHEIBEL, Markus, 63450 Hanau (DE); ALBERT, Tamara, 63110 Rodgau (DE)
(74) Vertreter: Heraeus IP
(86) Internationale Anmeldenummer: PCT/EP2018/055132
(87) Internationale Veröffentlichungsnummer: WO 2019/025033

(56) Entgegenhaltungen:
- EP-A1- 1 044 942
- WO-A1-2015/193035

## Beschreibung

Die Erfindung betrifft eine Zusammensetzung, die durch Vermischen, erforderlichenfalls mit Wasser, in eine wässrige hydraulisch härtbare als Umhüllungsmasse verwendbare Zubereitung überführt werden kann. Die wässrige Umhüllungsmasse kann zur Herstellung einer hydraulisch gehärteten Umhüllung einer elektronischen Komponente verwendet werden.

Der hierin verwendete Begriff "elektronische Komponente" umfasst neben passiven elektronischen Bauteilen insbesondere Halbleitermodule und unter letzteren insbesondere leistungselektronische Baugruppen.

Unter Halbleitermodulen werden hierin elektronische oder leistungselektronische Baugruppen umfassend mindestens ein Substrat (als Schaltungsträger), mindestens einen Halbleiterbaustein (Halbleiter) sowie gegebenenfalls mindestens ein passives elektronisches Bauteil verstanden. Der mindestens eine Halbleiterbaustein kann dabei selber schon teilweise oder vollständig vorumhüllt sein, beispielsweise mit einer Ummantelung auf Epoxidharzbasis.

Beispiele für Substrate sind IMS-Substrate (insulated metal-Substrate), DCB-Substrate (direct copper bonded-Substrate), AMB-Substrate (active metal brazing-Substrate), keramische Substrate, Metallkeramiksubstrate, PCBs (printed circuit boards) und Leadframes.

Beispiele für Halbleiterbausteine sind Dioden, LEDs (light emitting diodes), Dies (Halbleiterchips), IGBTs (insulated-gate bipolar transistors, Bipolartransistoren mit isolierter Gate-Elektrode), ICs (integrated circuits, integrierte Schaltungen) und MOSFETs (metal-oxide-semiconductor field-effect transistors, Metall-Oxid-Halbleiter-Feldeffekttransistoren). Bei dem oder den Halbleiterbausteinen handelt es sich insbesondere um während des bestimmungsgemäßen Betriebs infolge Verlustleistung beträchtliche Wärme entwickelnde, d.h. ohne Umhüllung und unverkapselt selbstzerstörerische Temperaturen von beispielsweise 100 bis > 200°C erreichende Halbleiter.

Beispiele für passive elektronische Bauteile sind Sensoren, Bodenplatten, Kühlkörper, Widerstände, Kondensatoren, Transformatoren, Drosseln und Spulen.

Der hierin verwendete Begriff "hydraulisches Härten" umfasst ein Abbinden in Gegenwart von Wasser respektive nach Zusatz von Wasser.

EP 1 044 942 A1 offenbart ein Verfahren zur Herstellung eines anorganischen Formprodukts, umfassend einen Schritt der Herstellung einer härtbaren Zusammensetzung, umfassend 100 Massenteile eines sauren Metallphosphats, 80 bis 200 Massenteile eines Härters und 0,1 bis 10 Massenteile Harnstoff, einen Schritt des Kombinierens von 100 Massenteilen der härtbaren Zusammensetzung und 5 bis 100 Massenteilen eines anorganischen Verstärkungsmaterials, um ein Formmaterial zu erhalten, einen Schritt des Formens des Formmaterials zu einer gewünschten Form, um ein halbstarres Material zu erhalten, und einen Schritt des Erhitzens des halbstarren Materials bei einer Temperatur von mindestens 120°C, um das Härten zu vervollständigen.

Pulverförmige Zusammensetzungen und daraus herstellbare wässrige Umhüllungsmassen in Form von Phosphatzement sind beispielsweise in WO2015/193035 A1 offenbart.

Aus solchen wässrigen Phosphatzement-Umhüllungsmassen hergestellte Umhüllungen von elektronischen Komponenten dienen insbesondere der elektrischen Isolierung und der Wärmeabführung aus der elektronischen Komponente nach außen während des Betriebs. Die fertige Umhüllung aus wässriger hydraulisch gehärteter Umhüllungsmasse soll eine gute Haftung zu der oder den Oberflächen der betreffenden elektronischen Komponente, beispielsweise zu den Oberflächen der verschiedenen Bauteile eines Halbleitermoduls und damit zu einer Vielfalt verschiedener Materialoberflächen aufweisen. Wichtig in dem Zusammenhang sind gute Fließeigenschaften der wässrigen Umhüllungsmasse als Voraussetzung für einen innigen Kontakt mit den Bauteiloberflächen, sowie im Hinblick auf Verarbeitungs- und Anwendungseigenschaften der wässrigen Umhüllungsmasse.

Wie sich überraschend gezeigt hat und der folgenden Offenbarung der Erfindung zu entnehmen ist, lassen sich die Fließeigenschaften wässriger Phosphatzement-Umhüllungsmassen durch Zusatz bestimmter Harnstoffverbindungen im Sinne einer Viskositätsveringerung unerwartet verbessern. Als Folge des verbesserten Fließverhaltens lässt sich auch eine verbesserte Haftung von aus den wässrigen Phosphatzement-Umhüllungsmassen mit dem Zusatz hergestellten hydraulisch gehärteten Umhüllungen zu den Oberflächen damit umhüllter elektronischer Komponenten beobachten.

Die Erfindung betrifft eine Zusammensetzung bestehend aus den Bestandteilen:
(a) 1 bis 30 Gew.-% (Gewichts-%) einer 1 bis 90 gew.-%igen wässrigen Phosphorsäure (H₃PO₄) und/oder mindestens eines Hydrogenphosphats ausgewählt aus der Gruppe bestehend aus Mono- und Dihydrogenphosphaten von Natrium, Kalium, Ammonium, Magnesium, Calcium, Aluminium, Zink, Eisen, Kobalt und Kupfer,
(b) 1 bis 40 Gew.-% mindestens einer Verbindung ausgewählt aus der Gruppe bestehend aus Oxiden, Hydroxiden und Oxidhydraten von Magnesium, Calcium, Eisen, Zink und Kupfer,
(c) 40 bis 95 Gew.-% mindestens eines partikelförmigen Füllstoffs ausgewählt aus der Gruppe bestehend aus Glas; Mono-, Oligo- und Polyphosphaten von Magnesium, Calcium, Barium und Aluminium; Calciumsulfat; Bariumsulfat; einfachen und komplexen Silikaten umfassend Natrium, Kalium, Calcium, Aluminium, Magnesium, Eisen und/oder Zirkonium; einfachen und komplexen Aluminaten umfassend Natrium, Kalium, Calcium, Magnesium und/oder Zirkonium; einfachen und komplexen Titanaten umfassend Natrium, Kalium, Calcium, Aluminium, Magnesium, Barium und/oder Zirkonium; einfachen und komplexen Zirkonaten umfassend Natrium, Kalium, Calcium, Aluminium und/oder Magnesium; Zirkoniumdioxid; Titandioxid; Aluminiumoxid; Siliziumdioxid; Siliziumcarbid; Aluminiumnitrid; Bornitrid und Siliziumnitrid, wobei es sich bei den komplexen Silikaten, Aluminaten, Titanaten und Zirkonaten nicht um Komplexverbindungen, sondern um Silikate, Aluminate, Titanate und Zirkonate mit mehr als einer Art von Kationen handelt,
(d) 1 bis 10 Gew.-% mindestens einer Harnstoffverbindung ausgewählt aus der Gruppe bestehend aus Imidazolidin-2-on, Allantoin und Imidazolidinylharnstoff, und
(e) 0 bis 15 Gew.-% mindestens eines von den Bestandteilen (a) bis (d) verschiedenen Bestandteils,
wobei sich die Gew.-%-Anteile der Bestandteile (a) bis (e) zu 100 Gew.-% addieren.

Jeder der Bestandteile (a), (b), (c), (d) und (e) kann einen oder mehrere verschiedene Inhaltsstoffe, in der weiteren Folge auch als Subbestandteile bezeichnet, umfassen.

Bei dem 1 bis 30 Gew.-%, bevorzugt 2 bis 15 Gew.-% der erfindungsgemäßen Zusammensetzung ausmachenden Bestandteil (a) handelt es sich um mindestens eine Substanz ausgewählt aus der Gruppe bestehend aus 1 bis 90 gew.-%iger wässriger Phosphorsäure (wässrige Lösung bestehend aus 1 bis 90 Gew.-% Phosphorsäure und dem zu 100 Gew.-% fehlenden Anteil an Wasser), Natriummonohydrogenphosphat, Kaliummonohydrogenphosphat, Ammoniummonohydrogenphosphat, Magnesiummonohydrogenphosphat, Calciummonohydrogenphosphat, Aluminiummonohydrogenphosphat, Zinkmonohydrogenphosphat, Eisenmonohydrogenphosphat, Kobaltmonohydrogenphosphat, Kupfermonohydrogenphosphat, Natriumdihydrogenphosphat, Kaliumdihydrogenphosphat, Ammoniumdihydrogenphosphat, Magnesiumdihydrogenphosphat, Calciumdihydrogenphosphat, Aluminiumdihydrogenphosphat, Zinkdihydrogenphosphat, Eisendihydrogenphosphat, Kobaltdihydrogenphosphat und Kupferdihydrogenphosphat. Mit anderen Worten, es handelt sich um 1 bis 90 gew.-%ige wässrige Phosphorsäure und/oder um mindestens ein Hydrogenphosphat ausgewählt aus der Gruppe bestehend aus Mono- und Dihydrogenphosphaten von Natrium, Kalium, Ammonium, Magnesium, Calcium, Aluminium, Zink, Eisen, Kobalt und Kupfer. Insbesondere handelt es sich um mindestens ein Hydrogenphosphat ausgewählt aus der Gruppe bestehend aus Mono- und Dihydrogenphosphaten von Magnesium, Kalium, Aluminium und Ammonium.

Im Falle der Abwesenheit von Phosphorsäure handelt es sich bei dem Bestandteil (a) respektive dessen Subbestandteilen bevorzugt um Feststoffpartikel, beispielsweise mit Teilchengrößen im Bereich von bis zu 1 mm.

Bei dem 1 bis 40 Gew.-%, bevorzugt 2 bis 15 Gew.-% der erfindungsgemäßen Zusammensetzung ausmachenden Bestandteil (b) handelt es sich um mindestens eine Verbindung ausgewählt aus der Gruppe bestehend aus Oxiden, Hydroxiden und Oxidhydraten von Magnesium, Calcium, Eisen, Zink und Kupfer, insbesondere um mindestens eine Verbindung ausgewählt aus der Gruppe bestehend aus Magnesiumoxid, Eisenoxid und Calciumoxid. Magnesiumoxid ist besonders bevorzugt.

Bevorzugt handelt es sich bei dem Bestandteil (b) respektive dessen Subbestandteilen um Feststoffpartikel, beispielsweise mit Teilchengrößen im Bereich von bis zu 0,3 mm.

Bei dem 40 bis 95 Gew.-%, bevorzugt 65 bis 90 Gew.-% der erfindungsgemäßen Zusammensetzung ausmachenden Bestandteil (c) handelt es sich um mindestens einen partikelförmigen Füllstoff ausgewählt aus der Gruppe bestehend aus Glas; Mono- , Oligo- und Polyphosphaten von Magnesium, Calcium, Barium und Aluminium; Calciumsulfat; Bariumsulfat; einfachen und komplexen Silikaten umfassend Natrium, Kalium, Calcium, Aluminium, Magnesium, Eisen und/oder Zirkonium; einfachen und komplexen Aluminaten umfassend Natrium, Kalium, Calcium, Magnesium und/oder Zirkonium; einfachen und komplexen Titanaten umfassend Natrium, Kalium, Calcium, Aluminium, Magnesium, Barium und/oder Zirkonium; einfachen und komplexen Zirkonaten umfassend Natrium, Kalium, Calcium, Aluminium und/oder Magnesium; Zirkoniumdioxid; Titandioxid; Aluminiumoxid; Siliziumdioxid, insbesondere in Form von Kieselsäure und Quarz; Siliziumcarbid; Aluminiumnitrid; Bornitrid und Siliziumnitrid. Zirkoniumsilikat, Kieselsäure und Quarz sind bevorzugt.

Im vorstehenden Absatz werden Mono-, Oligo- und Polyphosphate erwähnt; zur Vermeidung von Missverständnissen, dabei handelt es sich im Gegensatz zu den Hydrogenphosphaten des Bestandteils (a) um von Wasserstoff freie Phosphate.

Im vorstehenden Absatz wird jeweils zwischen einfachen und komplexen Silikaten, Aluminaten, Titanaten und Zirkonaten unterschieden. Bei den komplexen Vertretern handelt es sich nicht etwa um Komplexverbindungen, vielmehr sind damit Silikate, Aluminate, Titanate und Zirkonate gemeint mit mehr als einer Art von Kationen, wie beispielsweise Natriumaluminiumsilikat, Calciumaluminiumsilikat, Bleizirkontitanat usw.

Die Teilchengrößen von Bestandteil (c) respektive dessen Subbestandteilen liegen beispielsweise im Bereich von 20 nm bis 0,3 mm oder sogar von 20 nm bis 1 mm.

Bei dem 1 bis 10 Gew.-%, bevorzugt 3 bis 8 Gew.-% der erfindungsgemäßen Zusammensetzung ausmachenden Bestandteil (d) handelt es sich um mindestens eine Harnstoffverbindung ausgewählt aus der Gruppe bestehend aus Imidazolidin-2-on, Allantoin und Imidazolidinylharnstoff, bevorzugt in Form von Feststoffpartikeln, beispielsweise mit Teilchengrößen im Bereich von bis zu 1 mm. Imidazolidin-2-on ist bevorzugt.

Bei dem 0 bis 15 Gew.-%, bevorzugt 0 bis 8 Gew.-% oder 2 bis 8 Gew.-% der erfindungsgemäßen Zusammensetzung ausmachenden Bestandteil (e) handelt es sich um ein oder mehrere von den Bestandteilen (a) bis (d) verschiedene Bestandteile. Beispiele umfassen insbesondere Additive wie Abbindeverzögerer (Topfzeitverlängerer), Entschäumer, Benetzungsmittel und Haftvermittler.

Bei dem Bestandteil (e) respektive dessen Subbestandteilen handelt es sich bevorzugt um Feststoffpartikel, beispielsweise mit Teilchengrößen im Bereich von bis zu 0,3 mm oder sogar bis zu 1mm. Es ist möglich, dass der Bestandteil (e) nicht fest, sondern beispielsweise flüssig ist oder nicht feste, beispielsweise flüssige Subbestandteile umfasst.

Folgende Tabelle illustriert einige Beispiele bevorzugter Ausführungsformen erfindungsgemäßer Zusammensetzungen.

| Bestandteil | Ausführungsform 1 | Ausführungsform 2 | Ausführungsform 3 |
|---|---|---|---|
| | | | |
| (a), insbesondere Kalium- und/oder Aluminiumdihydrogenphosphat | 3 - 9 Gew.-% | 6 - 12 Gew.-% | 12 - 23 Gew.-% |
| (b), insbesondere Magnesiumoxid | 3 - 8 Gew.-% | 5 - 14 Gew.-% | 8 - 19 Gew.-% |
| (c), insbesondere Zirkoniumsilikat | 70 - 90 Gew.-% | 55 - 80 Gew.-% | 45 - 65 Gew.-% |
| (d), insbesondere Imidazolidin-2-on | 3 - 7 Gew.-% | 4 - 8 Gew.-% | 5 - 10 Gew.-% |
| (e) | 0 - 6 Gew.-% | 5 - 11 Gew.-% | 8 - 15 Gew.-% |

Die erfindungsgemäße Zusammensetzung besteht aus den Bestandteilen (a) bis (e), d.h. die Gew.-%-Anteile der Bestandteile (a) bis (e) addieren sich zu 100 Gew.-% der erfindungsgemäßen Zusammensetzung. Falls kein Bestandteil (e) enthalten ist, addieren sich die Gew.-%-Anteile der Bestandteile (a) bis (d) zu 100 Gew.-% der erfindungsgemäßen Zusammensetzung.

Die die Bestandteile (a) bis (d) respektive (a) bis (e) umfassende erfindungsgemäße Zusammensetzung kann als einkomponentige Mischung, d.h. als fertig bereitete Zusammensetzung bereitgestellt werden. Falls Bestandteil (a) dabei Phosphorsäure umfasst, ist eine solche einkomponentige erfindungsgemäße Zusammensetzung nur kurzzeitig lagerfähig, beispielsweise nur bis zu 2 Stunden. Mit Ausnahme einkomponentiger erfindungsgemäßer Zusammensetzungen mit einem Bestandteil (a), der Phosphorsäure umfasst, werden einkomponentige erfindungsgemäße Zusammensetzungen bevorzugt in partikulärer Form, beispielsweise in Pulverform bereitgestellt.

Die Bestandteile (a) bis (d) respektive (a) bis (e) liegen in der einkomponentigen partikulären erfindungsgemäßen Zusammensetzung innig miteinander vermischt, insbesondere als stochastisch homogene Mischung vor. Die einkomponentige partikuläre Zusammensetzung zeigt bevorzugt keine Klumpenbildung und ist rieselfähig.

Alternativ zur Bereitstellung der erfindungsgemäßen Zusammensetzung als Einkomponentensystem kann es zweckmäßig sein, die erfindungsgemäße Zusammensetzung als Zwei- oder Mehrkomponenten-System bereitzustellen, beispielsweise im Falle einer erfindungsgemäßen Zusammensetzung mit einem Bestandteil (a), der Phosphorsäure umfasst.

Um Verwechslungen vorzubeugen, hierin wird zwischen Bestandteilen (a) bis (e), Subbestandteilen dieser Bestandteile und Komponenten des Zwei- oder Mehrkomponenten-Systems unterschieden.

Falls Bestandteil (a) Phosphorsäure umfasst, können die Bestandteile (a) bis (e) respektive Subbestandteile davon beliebig auf die Komponenten der zwei- oder mehrkomponentig bereitgestellten erfindungsgemäßen Zusammensetzung verteilt werden bzw. sein, vorausgesetzt die Bestandteile (a) und (b) liegen separat voneinander vor.

Falls Bestandteil (a) keine Phosphorsäure umfasst, können die Bestandteile (a) bis (e) respektive Subbestandteile davon beliebig auf die Komponenten der zwei- oder mehrkomponentig bereitgestellten erfindungsgemäßen Zusammensetzung verteilt werden bzw. sein. Bevorzugt liegen auch hier die Bestandteile (a) und (b) separat voneinander vor.

Bevorzugt liegen die Komponenten des Zwei- oder Mehrkomponenten-Systems in einer dem vorerwähnten Mengenverhältnis der Bestandteile (a) bis (d) respektive (a) bis (e) entsprechenden Bereitstellungsmenge vor, mit anderen Worten, fertig portioniert und somit unmittelbar ohne Abwiegen oder Abmessen miteinander zur erfindungsgemäßen Zusammensetzung vermischbar. Falls Bestandteil (a) dabei Phosphorsäure umfasst, ist eine solche einkomponentige erfindungsgemäße Zusammensetzung, wie vorerwähnt, nur kurzzeitig lagerfähig.

Mit Ausnahme von Phosphorsäure umfassenden Komponenten werden die separaten, zwecks Zubereitung der fertigen erfindungsgemäßen Zusammensetzung miteinander und erforderlichenfalls mit separat bereitgestelltem Wasser zu vermischenden zwei oder mehr Komponenten bevorzugt in partikulärer Form bereitgestellt, beispielsweise in Pulverform. Dabei liegen mehr als einen, also zwei oder mehrere verschiedene Bestandteile und/oder Subbestandteile umfassende partikuläre oder pulverförmige Komponenten des Zwei- oder Mehrkomponentensystems als innige Mischung vor, insbesondere als stochastisch homogene Mischung; solche partikulären Komponenten zeigen bevorzugt keine Klumpenbildung und sind rieselfähig.

Sowohl die partikuläre einkomponentige erfindungsgemäße Zusammensetzung als auch partikuläre Komponenten der zwei- oder mehrkomponentig bereitgestellten erfindungsgemäßen Zusammensetzung können nach üblichen dem Fachmann bekannten Verfahren zur Herstellung rieselfähiger partikulärer Zusammensetzungen hergestellt werden. Beispielhaft seien Taumelmischen, Intensivmischen, Trockenvermahlung und Luftblending als Herstellungsverfahren erwähnt.

Wie vorerwähnt betrifft die Erfindung auch eine als Umhüllungsmasse verwendbare wässrige hydraulisch härtbare Zubereitung. Im Allgemeinen enthält eine wässrige hydraulisch härtbare Zubereitung der in Rede stehenden Art keinen Säureüberschuss; mit anderen Worten, im Allgemeinen kann der basische Bestandteil (b) nach Art und Menge so bemessen sein, dass die von Bestandteil (a) bereitgestellten Säureäquivalente sowie eventuelle weitere Säureäquivalente aus den Bestandteilen (c) und (e) vollständig neutralisiert, bevorzugt überneutralisiert werden können.

In manchen Ausführungsformen kann die erfindungsgemäße Zusammensetzung an sich schon eine wässrige hydraulisch härtbare Zubereitung im vorerwähnten Sinne sein bzw. eine solche darstellen, d.h. es handelt sich dann um eine einer Vermischung mit separat bereitgestelltem Wasser nicht oder nicht mehr bedürfende erfindungsgemäße Zusammensetzung. Beispiele sind solche Ausführungsformen einkomponentig bereitgestellter erfindungsgemäßer Zusammensetzungen mit einem Bestandteil (a), der eine entsprechend große Menge einer niedrig konzentrierten wässrigen Phosphorsäure umfasst. Entsprechendes gilt im Falle zwei- oder mehrkomponentig bereitgestellter erfindungsgemäßer Zusammensetzungen mit einem derartigen Bestandteil (a), d.h. eine betreffende durch Vermischen der zwei oder mehr Komponenten hergestellte erfindungsgemäße Zusammensetzung kann gegebenenfalls an sich schon eine wässrige hydraulisch härtbare Zubereitung im vorerwähnten Sinne sein bzw. eine solche darstellen, ohne einer Vermischung mit separat bereitgestelltem Wasser zu bedürfen.

In anderen Ausführungsformen hingegen ist der Zusatz von bzw. das Vermischen mit separat bereitgestelltem Wasser erforderlich. Beispiele sind insbesondere erfindungsgemäße Zusammensetzungen mit einem phosphorsäurefreien Bestandteil (a). Weitere Beispiele sind erfindungsgemäße Zusammensetzungen mit einem Bestandteil (a), der zwar Phosphorsäure, zugleich jedoch nur wenig Wasser umfasst. Hier kann die erfindungsgemäße Zusammensetzung mit separat bereitgestelltem Wasser zu einer wässrigen hydraulisch härtbaren Zubereitung vermischt werden.

Hierin ist mehrfach vom erforderlichen oder nicht erforderlichen Vermischen mit separat bereitgestelltem Wasser die Rede. Erforderlich ist das Vermischen mit separat bereitgestelltem Wasser insbesondere dann, wenn die Gesamtheit der Bestandteile der erfindungsgemäßen Zusammensetzung kein oder zu wenig Wasser umfasst, um als Produkt des Vermischens aller Bestandteile ohne Zusatz separat bereitgestellten Wassers zu einer als wässrige Umhüllungsmasse verwendbaren wässrigen hydraulisch härtbaren Zubereitung mit einer Anfangsviskosität beispielsweise im Bereich von 2 bis 25 Pa s zu gelangen. Der Begriff der Anfangsviskosität sowie deren Bestimmung wird nachstehend noch erläutert.

Beispielsweise können 100 Gewichtsteile der erfindungsgemäßen einkomponentigen und bevorzugt partikulären Zusammensetzung mit 5 bis 30 Gewichtsteilen, bevorzugt 6 bis 15 Gewichtsteilen Wasser vermischt werden.

Bei der Herstellung der wässrigen hydraulisch härtbaren Zubereitung unter Verwendung der zwei- oder mehrkomponentig bereitgestellten erfindungsgemäßen Zusammensetzung können deren einzelne Komponenten und das erforderlichenfalls separat bereitgestellte Wasser in beliebiger Reihenfolge, gegebenenfalls auch portionsweise, miteinander vermischt werden. Falls separat bereitgestelltes Wasser zugesetzt wird, ist selbstverständlich insgesamt ein gewünschtes Mengenverhältnis von erfindungsgemäßer Zusammensetzung und Wasser einzuhalten, beispielsweise das vorerwähnte Mengenverhältnis von 100 Gewichtsteilen der erfindungsgemäßen Zusammensetzung: 5 bis 30, bevorzugt 6 bis 15 Gewichtsteilen Wasser. Es ist dabei möglich, zunächst Zwischenprodukte in Form von Vormischungen aus zwei oder mehreren Komponenten ohne Wasser und/oder aus einer oder mehreren Komponenten mit Wasser herzustellen. Bei wässrigen Vormischungen kann es sich gegebenenfalls um wässrige Lösungen handeln, beispielsweise wässrige Lösungen der Bestandteile (a), (d) oder (e) oder eventueller Subbestandteile davon. Es kann zweckmäßig sein, wässrige Vormischungen mit dem Bestandteil (b) und mindestens einem sauren (in Gegenwart von Wasser H₃O⁺-Ionen bildenden) Bestandteil respektive Subbestandteil ausgewählt unter den Bestandteilen (a), (c), und (e) respektive Subbestandteilen davon nicht länger als beispielsweise bis zu 24 Stunden vor dem finalen Vermischen zur wässrigen hydraulisch härtbaren Zubereitung herzustellen. Ähnliches gilt für Bestandteil (b) oder Subbestandteile des Bestandteils (b) umfassende, von sauren Bestandteilen oder Subbestandteilen jedoch freie wässrige Vormischungen; hier ist es zweckmäßig, solche Vormischungen nicht länger als beispielsweise bis zu 48 Stunden vor dem finalen Vermischen zur wässrigen hydraulisch härtbaren Zubereitung herzustellen.

Beispiele für beim finalen Vermischen zur wässrigen hydraulisch härtbaren Zubereitung unter Verwendung der zwei- oder mehrkomponentigen erfindungsgemäßen Zusammensetzung einsetzbare Mischverfahren sind Verrühren und Intensivmischen, beispielsweise Intensivmischen unter Verwendung von Planetenmischern.

Die beim Vermischen der erfindungsgemäßen ein- oder mehrkomponentigen Zusammensetzung mit oder, falls nicht erforderlich, ohne Verwendung von separat bereitgestelltem Wasser erhältliche wässrige hydraulisch härtbare Zubereitung zeichnet sich durch eine initial und während eines Verarbeitungszeitraums (Topfzeit) von beispielsweise bis zu einer Stunde gute Fließfähigkeit aus, die naturgemäß im Zuge des hydraulischen Härtens abnimmt. Die Fließfähigkeit kann beispielsweise ausgedrückt als Anfangsviskosität bestimmt werden.

Die Anfangsviskosität kann beispielsweise gemessen werden mittels Rotationsviskosimetrie (Messbedingungen: Platte-Platte-Messprinzip, Plattendurchmesser 25 mm, Messspalt 1 mm, Probentemperatur 20°C, konstante Scherrate 36 min⁻¹, Bestimmung des Viskositätswertes nach einer Messdauer von 2 Minuten). Da es regelmäßig möglich ist, die erfindungsgemäße Zusammensetzung mit dem Wasser innerhalb von 5 Minuten zu einer homogenen wässrigen hydraulisch härtbaren Zubereitung zu vermischen und zur Viskositätsmessung vorzubereiten, wird die Anfangsviskosität nach 5 Minuten gerechnet ab erstem Inkontaktbringen von erfindungsgemäßer Zusammensetzung und Wasser gemessen oder, falls ein Vermischen mit separat bereitgestelltem Wasser nicht erforderlich ist, ab Fertigstellung der an sich schon die wässrige hydraulisch härtbare Zubereitung darstellenden erfindungsgemäßen Zusammensetzung. So gemessene Anfangsviskositäten liegen ohne Zusatz der mindestens einen Harnstoffverbindung (d) beispielweise im Bereich von 15 bis 50 Pa s. Beim erfindungsgemäßen Zusatz der mindestens einen Harnstoffverbindung (d) liegen sie niedriger, beispielweise im Bereich von 2 bis 25 Pa s.

Die wässrige, fließfähige und hydraulisch härtbare Zubereitung kann als wässrige Umhüllungsmasse für elektronische Komponenten verwendet werden. Der Kürze halber wird in der weiteren Folge der Begriff "wässrige Umhüllungsmasse" verwendet.

Die wässrige Umhüllungsmasse kann zur Herstellung einer hydraulisch gehärteten Umhüllung von elektronischen Komponenten verwendet werden. Das Herstellungsverfahren umfasst die Schritte:
(1) Bereitstellen einer zu umhüllenden elektronischen Komponente,
(2) Bereitstellen einer wie vorerwähnt hergestellten wässrigen Umhüllungsmasse,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.

In Schritt (1) wird eine zu umhüllende elektronische Komponente bereitgestellt, beispielsweise ein passives elektronisches Bauteil oder ein Halbleitermodul, letzteres insbesondere in Form einer leistungselektronischen Baugruppe.

Bezüglich Schritt (2) wird auf das Vorerwähnte verwiesen.

Bevorzugt wird Schritt (3) unverzüglich, beispielsweise innerhalb von 60 Minuten, bevorzugt innerhalb von 10 Minuten nach Beendigung von Schritt (2) durchgeführt.

In Schritt (3) erfolgt das Umhüllen der in Schritt (1) bereitgestellten elektronischen Komponente mit der gemäß Schritt (2) bereitgestellten wässrigen Umhüllungsmasse. Bevorzugte Applikationsmethoden sind Vergießen, Tauchen und Spritzgießen. Das Vergießen kann mittels üblichen, dem Fachmann bekannten Methoden erfolgen, beispielsweise durch Schwerkraft-, druckunterstützten oder druckvermindertem Verguss. Dabei kann es zweckmäßig sein, die zu umhüllende elektronische Komponente mit Halbschalenformen zu umschließen und dann mit der gießfähigen Umhüllungsmasse zu füllen. Das Umhüllen kann als teilweises oder vollständiges Umhüllen erfolgen. Beispielsweise kann bei der Umhüllung eines Halbleitermoduls so gearbeitet werden, dass die Umhüllungsmasse mit dem Halbleiterbaustein verbundene elektrische Kontaktierungselemente wie beispielsweise Bonddrähte, Bändchen und/oder ein Substrat teilweise oder vollständig umhüllt. Teilweise Umhüllung bedeutet dabei, dass ein oder mehrere der Kontaktierungselemente unvollständig und/oder ein oder mehrere der Kontaktierungselemente nicht umhüllt sind, während vollständige Umhüllung bedeutet, dass alle Kontaktierungselemente vollständig umhüllt sind. Das Vergießen kann aber beispielsweise auch so erfolgen, dass die Umhüllungsmasse als dem Fachmann bekanntes "glob-top" ausgebildet wird.

Im auf Schritt (3) folgenden Schritt (4) wird die wässrige die elektronische Komponente umhüllende Umhüllungsmasse hydraulisch gehärtet. Genauer gesagt, findet der wesentliche Teil des hydraulischen Härtens bis hin zum Abbinden in Schritt (4) statt; selbstverständlich hat das hydraulische Härten schon ab dem Moment begonnen, in dem die Bestandteile (a) und (b) in Gegenwart von Wasser miteinander in Kontakt gekommen sind, d.h. schon im Zuge von Schritt (2). Während und nach dem eigentlichen Abbinden kann ein Trocknen im Sinne einer Entfernung von Wasser bzw. des Wassers erfolgen. Abbinden und Trocknen können während beispielsweise 30 bis 300 Minuten in einem Temperaturbereich von beispielsweise 20 bis 300 °C erfolgen.

Im Falle des Arbeitens mit Halbschalenformen in Schritt (3) kann die umhüllte elektronische Komponente nach der hydraulischen Härtung gemäß Schritt (4) und Öffnen der Halbschalen letzteren entnommen werden.

Die Erfindung betrifft auch eine nach dem die Schritte (1) bis (4) umfassenden Verfahren hergestellte hydraulisch gehärtete Umhüllung einer elektronischen Komponente.

### Beispiele

Allgemeine Durchführung:
Die in nachfolgender Tabelle beschriebenen pulverförmigen
Feststoffzusammensetzungen wurden in einen Becher mit Schraubdeckel eingewogen. Nach Verschließen des Bechers wurde die jeweilige Zusammensetzung manuell mittels Schütteln homogenisiert und dann zu in einem zweiten Becher vorgelegtem Wasser gegeben und innerhalb 5 Minuten durch intensives Rühren homogenisiert. Das Mischungsverhältnis betrug jeweils 100 Gew.-Teile Feststoffzusammensetzung: 10 Gew.-Teile Wasser. Die so erhaltene wässrige Zubereitung wurde in die Messzelle eines Rheometers gegeben und es wurde die jeweilige Anfangsviskosität entsprechend den Ausführungen in der vorhergehenden Beschreibung bestimmt.

| **Beispiel** | **1** | **2** | **3** |
|---|---|---|---|
| **Bestandteile:** | **Gewichtsteile in g** | | |
| (a) Kaliumdihydrogenphosphat | 4,6 | 4,6 | 4,6 |
| (b) Magnesiumoxid D₅₀ = 18 µm | 3,8 | 3,8 | 3,8 |
| (c) Zirkoniumsilikat D₅₀ = 10 µm | 48,8 | 48,8 | 48,8 |
| (d) Imidazolidin-2-on | 0 | 2,5 | 5,2 |
| Anfangsviskosität [Pa·s] | 26,2 | 12,4 | 6,6 |

| | | | |
|---|---|---|---|
| D₅₀= mittlerer Partikeldurchmesser | | | |

Aus den für die Beispiele 1 bis 3 bestimmten Anfangsviskositäten lässt sich der die Fließfähigkeit verbessernde Effekt des Zusatzes von Imidazolidin-2-on unmittelbar erkennen.

## Patentansprüche

1. Zusammensetzung bestehend aus den Bestandteilen:
(a) 1 bis 30 Gew.-% einer 1 bis 90 gew.-%igen wässrigen Phosphorsäure und/oder mindestens eines Hydrogenphosphats ausgewählt aus der Gruppe bestehend aus Mono- und Dihydrogenphosphaten von Natrium, Kalium, Ammonium, Magnesium, Calcium, Aluminium, Zink, Eisen, Kobalt und Kupfer,
(b) 1 bis 40 Gew.-% mindestens einer Verbindung ausgewählt aus der Gruppe bestehend aus Oxiden, Hydroxiden und Oxidhydraten von Magnesium, Calcium, Eisen, Zink und Kupfer,
(c) 40 bis 95 Gew.-% mindestens eines partikelförmigen Füllstoffs ausgewählt aus der Gruppe bestehend aus Glas; Mono-, Oligo- und Polyphosphaten von Magnesium, Calcium, Barium und Aluminium; Calciumsulfat; Bariumsulfat; einfachen und komplexen Silikaten umfassend Natrium, Kalium, Calcium, Aluminium, Magnesium, Eisen und/oder Zirkonium; einfachen und komplexen Aluminaten umfassend Natrium, Kalium, Calcium, Magnesium und/oder Zirkonium; einfachen und komplexen Titanaten umfassend Natrium, Kalium, Calcium, Aluminium, Magnesium, Barium und/oder Zirkonium; einfachen und komplexen Zirkonaten umfassend Natrium, Kalium, Calcium, Aluminium und/oder Magnesium; Zirkoniumdioxid; Titandioxid; Aluminiumoxid; Siliziumdioxid; Siliziumcarbid; Aluminiumnitrid; Bornitrid und Siliziumnitrid, wobei es sich bei den komplexen Silikaten, Aluminaten, Titanaten und Zirkonaten nicht um Komplexverbindungen, sondern um Silikate, Aluminate, Titanate und Zirkonate mit mehr als einer Art von Kationen handelt,
(d) 1 bis 10 Gew.-% mindestens einer Harnstoffverbindung ausgewählt aus der Gruppe bestehend aus Imidazolidin-2-on, Allantoin und Imidazolidinylharnstoff, und
(e) 0 bis 15 Gew.-% mindestens eines von den Bestandteilen (a) bis (d) verschiedenen Bestandteils,
wobei sich die Gew.-%-Anteile der Bestandteile (a) bis (e) zu 100 Gew.-% addieren.

2. Zusammensetzung nach Anspruch 1, wobei es sich bei Bestandteil (a) um mindestens ein Hydrogenphosphat ausgewählt aus der Gruppe bestehend aus Mono- und Dihydrogenphosphaten von Magnesium, Kalium, Aluminium und Ammonium handelt.

3. Zusammensetzung nach Anspruch 1 oder 2, wobei es sich bei Bestandteil (b) um mindestens eine Verbindung ausgewählt aus der Gruppe bestehend aus Magnesiumoxid, Eisenoxid und Calciumoxid handelt.

4. Zusammensetzung nach Anspruch 1, 2 oder 3, wobei es sich bei Bestandteil (c) um mindestens einen partikelförmigen Füllstoff ausgewählt aus der Gruppe bestehend aus Zirkoniumsilikat, Kieselsäure und Quarz handelt.

5. Zusammensetzung nach einem der vorhergehenden Ansprüche, wobei es sich bei Bestandteil (d) um Imidazolidin-2-on handelt.

6. Zusammensetzung nach einem der vorhergehenden Ansprüche in Form einer einkomponentigen Mischung oder eines Zwei- oder Mehrkomponenten-Systems.

7. Wässrige hydraulisch härtbare Zubereitung herstellbar durch Vermischen einer Zusammensetzung nach einem der vorhergehenden Ansprüche mit Wasser.

8. Wässrige hydraulisch härtbare Zubereitung nach Anspruch 7, wobei das Mischungsverhältnis 100 Gewichtsteile der Zusammensetzung nach einem der Ansprüche 1 bis 6 und 5 bis 30 Gewichtsteile Wasser beträgt.

9. Verwendung einer wässrigen hydraulisch härtbaren Zubereitung nach Anspruch 7 oder 8 oder einer keiner Vermischung mit separat bereitgestelltem Wasser bedürfenden Zusammensetzung nach einem der Ansprüche 1 bis 6 als wässrige Umhüllungsmasse für elektronische Komponenten.

10. Verfahren zur Herstellung einer hydraulisch gehärteten Umhüllung einer elektronischen Komponente, umfassend die Schritte:
(1) Bereitstellen einer zu umhüllenden elektronischen Komponente,
(2) Bereitstellen einer wässrigen Umhüllungsmasse in Form einer wässrigen hydraulisch härtbaren Zubereitung nach Anspruch 7 oder 8 oder in Form einer keiner Vermischung mit separat bereitgestelltem Wasser bedürfenden Zusammensetzung nach einem der Ansprüche 1 bis 6,
(3) Umhüllen der in Schritt (1) bereitgestellten elektronischen Komponente mit der in Schritt (2) bereitgestellten wässrigen Umhüllungsmasse, und
(4) hydraulisches Härten der wässrigen die elektronische Komponente nach Beendigung von Schritt (3) umhüllenden Umhüllungsmasse.

11. Verfahren nach Anspruch 10, wobei die zu umhüllende elektronische Komponente ein passives elektronisches Bauteil oder ein Halbleitermodul ist.

12. Nach einem Verfahren gemäß Anspruch 10 oder 11 hergestellte hydraulisch gehärtete Umhüllung einer elektronischen Komponente.

## Claims

1. Composition consisting of the components:
(a) 1 to 30 wt% of a 1 to 90 wt.% aqueous phosphoric acid and/or at least one hydrogen phosphate selected from the group consisting of mono- and dihydrogen phosphates of sodium, potassium, ammonium, magnesium, calcium, aluminum, zinc, iron, cobalt and copper,
(b) 1 to 40 wt.% of at least one compound selected from the group consisting of oxides, hydroxides and oxide hydrates of magnesium, calcium, iron, zinc and copper,
(c) 40 to 95 wt.% of at least one particulate filler selected from the group consisting of: glass; mono-, oligo- and polyphosphates of magnesium, calcium, barium and aluminum; calcium sulfate; barium sulfate; simple and complex silicates comprising sodium, potassium, calcium, aluminum, magnesium, iron and/or zirconium; simple and complex aluminates comprising sodium, potassium, calcium, magnesium and/or zirconium; simple and complex titanates comprising sodium, potassium, calcium, aluminum, magnesium, barium and/or zirconium; simple and complex zirconates comprising sodium, potassium, calcium, aluminum and/or magnesium; zirconium dioxide; titanium dioxide; aluminum oxide; silicon dioxide; silicon carbide; aluminum nitride; boron nitride; and silicon dioxide, wherein the complex silicates, aluminates, titanates and zirconates are not complex compounds but rather silicates, aluminates, titanates and zirconates having more than one type of cation,
(d) 1 to 10 wt.% of at least one urea compound selected from the group consisting of imidazolidin-2-one, allantoin and imidazolidinyl urea, and
(e) 0 to 15 wt.% of at least one component different from the components (a) to (d),
wherein the wt.% fractions of the components (a) to (e) add up to 100 wt.%.

2. Composition according to claim 1, wherein component (a) is at least one hydrogen phosphate selected from the group consisting of mono- and dihydrogen phosphates of magnesium, potassium, aluminum and ammonium.

3. Composition according to either claim 1 or claim 2, wherein component (b) is at least one compound selected from the group consisting of magnesium oxide, iron oxide and calcium oxide.

4. Composition according to claims 1, 2 or 3, wherein component (c) is at least one particulate filler selected from the group consisting of zirconium silicate, silica and quartz.

5. Composition according to any of the preceding claims, wherein component (d) is imidazolidin-2-one.

6. Composition according to any of the preceding claims in the form of a one-component mixture or a two-component or multi-component system.

7. Aqueous hydraulically curable preparation which can be prepared by mixing a composition according to any of the preceding claims with water.

8. Aqueous hydraulically curable preparation according to claim 7, wherein the mixing ratio is 100 parts by weight of the composition according to any of claims 1 to 6, and 5 to 30 parts by weight of water.

9. Use of an aqueous hydraulically curable preparation according to either claim 7 or claim 8, or a composition according to any of claims 1 to 6 that does not require mixing with separately provided water, as an aqueous coating material for electronic components.

10. Method for preparing a hydraulically cured coating of an electronic component, comprising the steps of:
(1) providing an electronic component to be coated,
(2) providing an aqueous coating material in the form of an aqueous hydraulically curable preparation according to either claim 7 or claim 8, or in the form of a composition according to any of claims 1 to 6 that does not require mixing with separately provided water,
(3) coating the electronic component provided in step (1) with the aqueous coating material provided in step (2), and
(4) hydraulically curing the aqueous coating material encasing the electronic component, after completion of step (3).

11. Method according to claim 10, wherein the electronic component to be coated is a passive electronic component or a semiconductor module.

12. Hydraulically cured coating of an electronic component produced according to a method according to either claim 10 or claim 11.

## Revendications

1. Composition constituée par les constituants suivants :
(a) 1 à 30 % en poids d'un acide phosphorique aqueux à 1 à 90 % en poids et/ou d'au moins un hydrogénophosphate choisi dans le groupe constitué par les monohydrogénophosphates et les dihydrogénophosphates de sodium, de potassium, d'ammonium, de magnésium, de calcium, d'aluminium, de zinc, de fer, de cobalt et de cuivre,
(b) 1 à 40 % en poids d'au moins un composé choisi dans le groupe constitué par les oxydes, les hydroxydes et les hydrates d'oxyde de magnésium, de calcium, de fer, de zinc et de cuivre,
(c) 40 à 95 % en poids d'au moins une charge particulaire choisie dans le groupe constitué par le verre ; les monophosphates, les oligophosphates et les polyphosphates de magnésium, de calcium, de baryum et d'aluminium ; le sulfate de calcium ; le sulfate de baryum ; les silicates simples et complexes comprenant du sodium, du potassium, du calcium, de l'aluminium, du magnésium, du fer et/ou du zirconium ; les aluminates simples et complexes comprenant du sodium, du potassium, du calcium, du magnésium et/ou du zirconium ; les titanates simples et complexes comprenant du sodium, du potassium, du calcium, de l'aluminium, du magnésium, du baryum et/ou du zirconium ; les zirconates simples et complexes comprenant du sodium, du potassium, du calcium, de l'aluminium et/ou du magnésium ; le dioxyde de zirconium ; le dioxyde de titane ; l'oxyde d'aluminium ; le dioxyde de silicium ; le carbure de silicium ; le nitrure d'aluminium ; le nitrure de bore et le nitrure de silicium, les silicates, aluminates, titanates et zirconates complexes n'étant pas des composés complexes mais des silicates, aluminates, titanates et zirconates comportant plus d'un type de cations,
(d) 1 à 10 % en poids d'au moins un composé d'urée choisi dans le groupe constitué par l'imidazolidin-2-one, l'allantoïne et l'imidazolidinylurée, et
(e) 0 à 15 % en poids d'au moins un constituant différant des constituants (a) à (d),
dans laquelle les proportions de % en poids des constituants (a) à (e) s'additionnent pour atteindre 100 % en poids.

2. Composition selon la revendication 1, dans laquelle le constituant (a) est au moins un hydrogénophosphate choisi dans le groupe constitué par les monohydrogénophosphates et les dihydrogénophosphates de magnésium, de potassium, d'aluminium et d'ammonium.

3. Composition selon la revendication 1 ou 2, dans laquelle le constituant (b) est au moins un composé choisi dans le groupe constitué par l'oxyde de magnésium, l'oxyde de fer et l'oxyde de calcium.

4. Composition selon la revendication 1, 2 ou 3, dans laquelle le constituant (c) est au moins une charge particulaire choisie dans le groupe constitué par le silicate de zirconium, l'acide silicique et le quartz.

5. Composition selon l'une quelconque des revendications précédentes, dans laquelle le constituant (d) est l'imidazolidin-2-one.

6. Composition selon l'une quelconque des revendications précédentes, sous la forme d'un mélange à un composant ou d'un système à deux composants ou plus.

7. Préparation aqueuse hydrauliquement durcissable pouvant être préparée par mélange d'une composition selon l'une quelconque des revendications précédentes avec de l'eau.

8. Préparation aqueuse hydrauliquement durcissable selon la revendication 7, dans laquelle le rapport de mélange est de 100 parties en poids de la composition selon l'une des revendications 1 à 6 et de 5 à 30 parties en poids d'eau.

9. Utilisation d'une préparation aqueuse hydrauliquement durcissable selon la revendication 7 ou 8 ou d'une composition ne nécessitant pas de mélange avec de l'eau fournie séparément selon l'une des revendications 1 à 6 en tant que matière d'enveloppe aqueuse pour des composants électroniques.

10. Procédé de fabrication d'une enveloppe durcie hydrauliquement d'un composant électronique, comprenant les étapes de :
(1) fourniture d'un composant électronique à envelopper,
(2) fourniture d'une matière d'enveloppe aqueuse sous la forme d'une préparation aqueuse hydrauliquement durcissable selon la revendication 7 ou 8 ou sous la forme d'une composition ne nécessitant pas de mélange avec de l'eau fournie séparément selon l'une quelconque des revendications 1 à 6,
(3) enveloppement du composant électronique fourni à l'étape (1) avec la matière d'enveloppe aqueuse fournie à l'étape (2), et
(4) durcissement hydraulique de la matière d'enveloppe aqueuse enveloppant le composant électronique après achèvement de l'étape (3).

11. Procédé selon la revendication 10, dans lequel le composant électronique à envelopper est une pièce électronique passive ou un module semi-conducteur.

12. Enveloppe d'un composant électronique durcie hydrauliquement fabriquée selon un procédé selon la revendication 10 ou 11.
